Europäisches Patentamt

European Patent Office

Office européen des brevets

(19)

(11) Veröffentlichungsnummer : **0 482 221 B1**

(12) **EUROPÄISCHE PATENTSCHRIFT**

(45) Veröffentlichungstag der Patentschrift :
**13.09.95 Patentblatt 95/37**

(51) Int. Cl.[6] : **H01L 39/24**

(21) Anmeldenummer : **90120137.6**

(22) Anmeldetag : **20.10.90**

(54) Verfahren zur Herstellung eines Hochtemperatur-Supraleiters vom Bi-Sr-Ca-Cu-O Typ.

(43) Veröffentlichungstag der Anmeldung :
**29.04.92 Patentblatt 92/18**

(45) Bekanntmachung des Hinweises auf die
Patenterteilung :
**13.09.95 Patentblatt 95/37**

(84) Benannte Vertragsstaaten :
**CH DE FR GB LI**

(56) Entgegenhaltungen :
**EP-A- 0 332 291**
**EP-A- 0 368 765**

(56) Entgegenhaltungen :
**SOLID STATE COMMUNICATIONS, Band 70,
Nr. 12, 1989, Seiten 1145-1146, Londen, GB; L.
YA. VINNIKOV et a.: "Observation of the flux
line lattice in high Tc- superconductor
Bi2.2Sr2CaCu2OX and T12Ba2CaCu2OX single crystals"**
**MATERIAL LETTERS, Band 8, Nr. 5, Juni 1989,
Seiten 165-170, Amsterdam, NL; A. PERRIN et
al.: "Annealing effects on the 110 K transition
in the Bi1Sr1CalCu2 oxide superconductor"**
**APPLIED PHYSICS LETTERS, Band 55, Nr. 23,
4. Dezember 1989, Seiten 2441-2443, New
York, US; K. HEINE et al.: "High-field critical
current densities in Bi2Sr2Ca1Cu2O8+X/Ag
wires"**

(73) Patentinhaber : **ASEA BROWN BOVERI AG
Haselstrasse 16
CH-5401 Baden (CH)**

(72) Erfinder : **Baumann, Thomas, Dr.
Schulstrasse 6
CH-5430 Wettingen (CH)**

**Beschreibung**

Verfahren zur Herstellung eines Hochtemperatur-Supraleiters vom Bi-Sr-Ca-Cu-O-Typ

TECHNISCHES GEBIET

Bei der Erfindung wird ausgegangen von einem Verfahren zur Herstellung eines Hochtemperatur-Supraleiters vom Bi-Sr-Ca-Cu-O-Typ nach dem Oberbegriff des Patentanspruchs 1.

STAND DER TECHNIK

Mit dem Oberbegriff des Patentanspruchs 1 nimmt die Erfindung auf einen Stand der Technik Bezug, wie er aus der DE-A1-3 830 092 bekannt ist. Dort werden die Oxide und/oder Karbonate des Wismuts, Strontiums, Kalziums und Kupfers im stöchiometrischen Verhältnis gemischt, bis zum Schmelzen auf 870 °C - 1100 °C erhitzt und dann in Kokillen gegossen, in denen die Schmelze erstarrt. Die so entstandenen Gußkörper werden 6 h - 30 h bei 780 °C - 850 °C getempert und danach 6 h bei 600 °C - 820 °C in Sauerstoffatmosphäre behandelt.

Dieses Verfahren erfordert eine Prozeßtemperatur deutlich oberhalb des Schmelzpunktes $T_m$, der für Bi-2212 in Luft bei $\approx$ 890 °C liegt.

Die derzeit bekannten keramischen Hochtemperatur-Supraleiter weisen ohne spezielle Orientierung der Kristallite bei 77 K eine für die meisten Anwendungen zu geringe Transportstromdichte auf, besonders im magnetischen Feld (kritische Transportstromdichte $j_c(B)$).

Ursachen hierfür sind

(a) die sogenannte "weak link"-Kopplung zwischen den einzelnen Kristalliten (siehe dazu für das System Y-Ba-Cu-O: J. Ekin et al., J.Appl.Phys. 62, S.4821-4828 (1987)); und

(b) der sogenannte "flux flow", d.h. eine schlechte Verankerung der magnetischen Flussschläuche (sog. "flux pinning"; siehe dazu für das System Y-Ba-Cu-O: Y. Yeshurun et al., Phys.Rev.Lett. 60, S.2202-2205).

Während das Magnetfeldverhalten von $j_c$ in $YBa_2Cu_3O_x$, den T1-Verbindungen und der Bi-Dreischichtverbindung von der "weak link"-Kopplung geprägt ist, fehlt diese in der Bi-Zweischichtverbindung Bi-2212 (Idealstöchiometrie: $Bi_2Sr_2Ca_1Cu_2O_x$), sofern diese durch einen Schmelzprozess hergestellt wurde. Dafür ist der "flux flow", das Flusslinien-Fliessen, um so ausgeprägter.

Die höchsten Werte für $j_c(77 K)$ in nicht-orientierter Keramik von Bi-2212 liegen derzeit bei ca. 1200 A/cm² im Nullfeld (Keramikleiter im Ag-Rohr; $j_c$-Kriterium: 0,1 μV/cm; siehe dazu: K. Heine et al., Appl.Phys.Lett. 55, S.2441-2443 (1989)) bzw. bei 1600 A/cm² (Keramikblock von 2 x 3 x 20 mm; $j_c$-Kriterium und Feldverhalten unbekannt; siehe dazu: EP-A2-0 351 844).

Kennzeichnend für beide Verfahren ist, dass die Maximaltemperatur der Aufschmelzung bei der Herstellung des Supraleiters nur 10-50°C über der Anfangstemperatur des inkongruenten Schmelzvorganges, der Schmelztemperatur $T_m$, von Bi-2212 liegt ($T_m \approx$ 890°C in Luft).

Die an sich hohen Werte von $j_c$ von 1200-1500 A/cm² bei diesen bekannten Bi-2212-Supraleitern nehmen jedoch schon in kleinen magnetischen Feldern stark ab; so ist z.B. $j_c$ (0.05 T (500 G)) nur noch ca. 1% des Nullfeld-Wertes, wodurch der Anwendbarkeit enge Grenzen gesetzt sind.

Es hat aus diesen Gründen nicht an Versuchen gefehlt, die kritische "weak link"-Kopplung zu vermeiden bzw. das "flux pinning" zu verbessern, um hohe kritische Stromdichten auch bei höheren Feldern zu erhalten.

So führen Textureffekte, die durch einen speziellen, sehr langsamen Schmelzprozess hervorgerufen werden (sog. "melt-textured growth"), in $YBa_2Cu_3O_x$ dazu, dass die erhaltenen Proben von mm-m Grösse Stromdichten von mehreren 10000 A/cm² aufweisen und kein "weak link"-Verhalten mehr zeigen (siehe dazu: S. Jin et al., Appl.Phys.Lett. 52, S.2074-2076).

Bei diesen Ergebnissen handelt es sich jedoch um Messungen an einzelnen Körnern (die bei diesem Herstellungsverfahren 1 cm und grösser sein können); eine einzige Korngrenze beschränkt die $j_c$-Werte dann (mindestens) wieder auf die für normale Keramik üblichen Werte.

Andererseits führt eine Zersetzung von $YBa_2Cu_4O_x$ zu $YBa_2Cu_3O_x$ zu submikroskopischen Ausscheidungen in den Kristalliten. Die Ausscheidungen wirken dann möglicherweise als Pinning-Zentren (siehe dazu: S. Jin et al., Appl.Phys.Lett. 56, S.1287 (1990)). Dies führt zu einer Steigerung von $j_c$ in den Körnern; ob eine Steigerung der Stromdichte zwischen den Kristalliten dadurch ebenfalls erreicht wird, ist nicht bekannt.

Ebenfalls wird von einer Steigerung der Stromdichte innerhalb der Kristallite durch Einbringen von Ca-bzw. CaCu-Oxidphasen in $LaBa_2Cu_3O_x$ (H. Masuda et al., Jpn.J.Appl.Phys. 28, S.L1226-L1229 (1989)) und Bi-2212 (D. Shi et al., Phys.Rev.B 40, S.5255-5258 (1989)) berichtet.

In einer (Bi,Pb)-Dreischichtverbindung bewirkt dieses Verfahren eine Erhöhung des Transportstromes von durchschnittlich 200 auf 400 A/cm² bei Abwesenheit externer Magnetfelder (siehe dazu: S. X. Dou et al.,

Supercond.Sci.Technol. 2, S.308-310 (1989)).

Zusammenfassend kann gesagt werden, dass bis jetzt kein Weg bekannt ist, wie bei keramischen Hochtemperatur-Supraleitern vom Bi-Sr-Ca-Cu-O-Typ durch Beseitigung der "weak links" bzw. durch Verbesserung des "flux pinning" $j_c$(B) bei 77 K über die Werte herkömmlicher guter Proben (d.h. $j_c$(0.05 T (500 G)) $\approx$ 10 A/cm$^2$ in Bi-2212) verbessert werden kann.

## DARSTELLUNG DER ERFINDUNG

Die Erfindung, wie sie im Patentanspruch 1 definiert ist, löst die Aufgabe, ein Verfahren zur Herstellung eines Hochtemperatur-Supraleiters vom Bi-Sr-Ca-Cu-O-Typ der eingangs genannten Art derart weiterzuentwickeln, daß ein Hochtemperatur-Supraleiter mit einer verbesserten kritischen Stromdichte $j_c$ auch bei höheren externen Magnetfeldern resultiert.

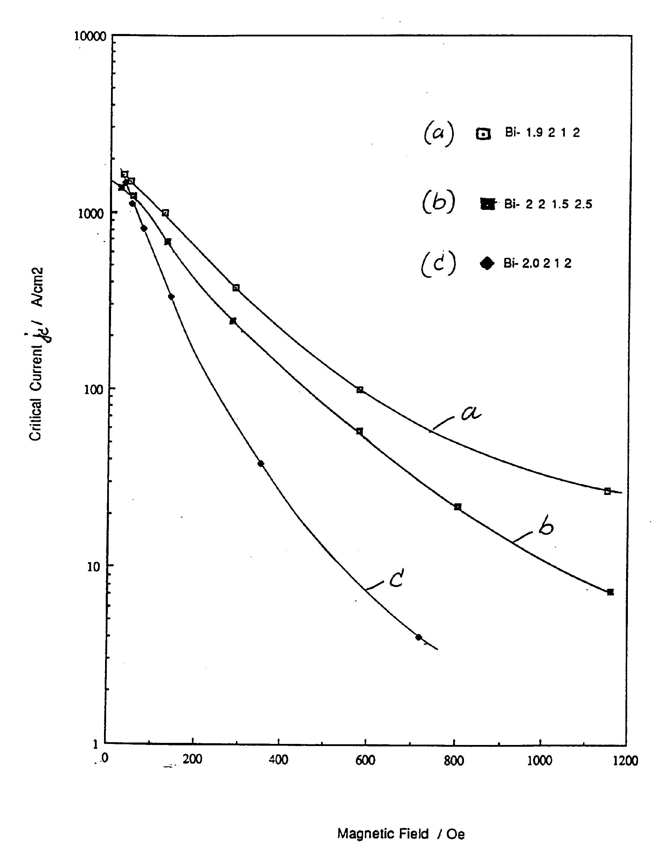

## KURZE BESCHREIBUNG DER ZEICHNUNG

Die Erfindung soll nachfolgend anhand von Ausführungsbeispielen näher erläutert werden.

Die einzige Figur zeigt dabei die gemessene Abhängigkeit der kritischen Stromdichte $j_c$ vom Magnetfeld für zwei bevorzugte Ausführungsformen eines Supraleiters nach der Erfindung im Vergleich zu einem herkömmlichen Bi-2212-Su-praleiter.

## WEGE ZUR AUSFÜHRUNG DER ERFINDUNG

Bei der Erfindung wird ausgegangen von der stöchiometrischen Bi-Zweischichtverbindung Bi-2212. Durch Wahl der Mengen der Ausgangssubstanzen in einem von dieser Idealstöchiometrie abweichenden, nichtstöchiometrischen Verhältnis und durch ein geeignetes Schmelzprozessieren wird dann ein Supraleiter erhalten, der ein verbessertes Pinning und dadurch ein erhöhtes $j_c$(B) aufweist.

Im Unterschied zu den von S. Shi et al. in dem eingangs genannten Artikel vorgeschlagenen Bi-Verbindungen mit den Mischungsverhältnissen 2:2:2:3, 2:2:3:4 und 2:2:4:5 ist die Nichtstöchiometrie bei den Supraleitern nach der Erfindung nur gering. Bessere Ergebnisse als mit einem Ueberschuss an Ca und Cu erzielt man dabei insbesondere mit einem Unterschuss an Bi (gleichbedeutend mit einem Ueberschuss von Sr, Ca und Cu).

Als Ausgangssubstanzen für den Schmelzprozess werden gemäss einem bevorzugten Ausführungsbeispiel der Erfindung die Oxide von Bi, Sr, Ca und Cu in der Zusammensetzung (2-x):2:1:2 eingewogen und gemischt, wobei $0,05 \leq x < 0,6$ gilt. Alternativ können statt den Oxiden alle Verbindungen bindungen der o.g. Elemente verwendet werden, die sich bei erhöhten Temperaturen, z.B. oberhalb 800°C, zu Oxiden zersetzen.

Die Mischungen können dann direkt für den anschliessenden Schmelzprozess verwendet werden. Besonders vorteilhaft ist es jedoch, die Mischung vor dem Schmelzen zunächst durch Glühen in Luft bei einer Temperatur unterhalb der Schmelztemperatur $T_m$, vorzugsweise bei etwa 850°C, in eine Bi-Zweischichtverbindung umzuwandeln.

Der Schmelzprozess selbst kann prinzipiell auf zwei Arten durchgeführt werden:

(a) Die Pulvermischung wird in einem Tiegel aufgeschmolzen und die Schmelze in Kokillen abgegossen, wie dies für die stöchiometrische Verbindung Bi-2212 z.B. in der eingangs zitierten DE-A1-38 30 092 beschrieben worden ist. Dieses Vorgehen erfordert eine Prozesstemperatur deutlich (z.B. mehrere 10 K) oberhalb des Schmelzpunktes $T_m$ (Beginn des inkongruenten Schmelzens bei Bi-2212 in Luft: $T_m \approx$ 890°C).

(b) Die Pulvermischung wird in eine gewünschte Form eingefüllt oder eingepresst, und dann aufgeschmolzen und erstarren gelassen. Da die Viskosität der Schmelze hierbei nur von untergeordneter Bedeutung ist, sind für diese Variante auch Prozesstemperaturen möglich, die dicht bei $T_m$, insbesondere nur wenige Grad Kelvin oberhalb liegen.

Nach dem Erstarren liegt das Material im wesentlichen als Bi-Einschichtverbindung vor. Die Bi-Einschichtverbindung wird in einer Nachbehandlung bei Temperaturen zwischen 400°C und 880°C in einer oxidierenden Atmosphäre (z.B. Luft oder $O_2$) zur Bi-Zweischichtverbindung umgewandelt.

Danach werden die Proben unter Sauerstoffausschluss (z.B. in $N_2$) auf Raumtemperatur abgekühlt.

Die erzielten Stromdichten $j_c$ der auf diese Weise hergestellten Proben hängen stark von der Art des Aufschmelzprozesses und der Länge der Nachbehandlung ab:

Schmelzprozess (a) in Verbindung mit einer kurzen Nachbehandlung (ca. 15 h) führt zu Proben mit $j_c$ von weniger als 100 A/cm$^2$ im Nullfeld. Material mit einem Bi-Unterschuss zeigt dabei 2-3 mal bessere $j_c$-Werte als vergleichbares stöchiometrisches Material. Dieser Wert lässt sich durch langes Nachbehandeln bei 700-850°C (>30 h) auf 200-500 A/cm$^2$ steigern.

Schmelzprozess (b) ermöglicht wesentlich höhere Stromdichten. Optimaler Wert von $j_c$ im Nullfeld für eine Probe der Zusammensetzung 1,9:2:1:2 ist 2100 A/cm$^2$, d.h. ca. 30% besser als der höchste aus dem Stand der Technik bekannte Wert. Die Steigerung gegenüber der ideal-stöchiometrischen Verbindung Bi-2212 ist im Magnetfeld noch ausgeprägter. So ist in Bi-(1,9)212 bei 0.05 T (500 G) noch $j_c$ = 140 A/cm$^2$, d.h. 15 mal mehr als in Bi-2212 (siehe auch die Figur).

Nachfolgend seien einige Ausführungsbeispiele für die Supraleiter nach der Erfindung und deren Herstellungsverfahren sowie Vergleichsbeispiele angegeben. Die gemessenen $j_c$(B)-Kurven zweier Ausführungsbeispiele und eines Vergleichsbeispiels sind in der Figur dargestellt.

## Ausführungsbeispiel 1

$Bi_2O_3$, $CuO$, $SrCO_3$ und $CaCO_3$ wurden entsprechend der Endzusammensetzung (1,9):2:1:2 eingewogen, gemischt und bei 850°C 40 h in Luft zersetzt und zur Bi-Zweischichtverbindung umgewandelt. Das Produkt wurde unter Hexan in einer Kugelmühle gemahlen und anschliessend gesiebt (Partikelgrösse $\leq$ 32 µm). Von diesem Pulver wurden Tabletten von ca. 1 mm Höhe und 13 mm Durchmesser gepresst. Diese Tabletten wurden in Ag-Formen 1 h bei 905°C unter 1 bar $O_2$ erschmolzen und in einem Zwei-Stufen-Prozess (13 h bei 860°C unter 1 bar $O_2$ und 60 h bei 800°C in Luft) nachbehandelt. Das anschliessende Abkühlen erfolgte unterhalb 700°C in einer $N_2$-Atmosphäre. Ohne Magnetfeld lag $j_c$ bei 1600 A/cm$^2$. Die in der Figur (Kurve a) gezeigte Magnetfeldabhängigkeit belegt, dass bei B = 0.05 T (500 G) $j_c$ ca. 15 mal höher ist als in reinem Bi-2212 (Kurve c) und ca. 2 mal höher als in Bi-22(1,5)(2,5) (Kurve b), obwohl $j_c$(B=0) für alle drei Substanzen vergleichbar ist.

## Ausführungsbeispiel 2

Es wurden die gleichen Prozesschritte durchgeführt wie beim Ausführungsbeispiel 1, jedoch mit einem Mischungsverhältnis der Ausgangssubstanzen von 2:2:(1,5):(2,5). Die $j_c$(B)-Abhängigkeit der erhaltenen Proben ist in der Figur als Kurve b wiedergegeben.

## Vergleichsbeispiel 1

Es wurden die gleichen Prozesschritte durchgeführt wie beim Ausführungsbeispiel 1, jedoch mit reinem, schmelzprozessierten Bi-2212-Pulver der Korngrösse $\leq$ 6 µm, welches kommerziell von der Firma Hoechst AG erhältlich ist. Die $j_c$(B)-Abhängigkeit der erhaltenen Proben ist in der Figur als Kurve c wiedergegeben.

## Ausführungsbeispiel 3

Grobkörniges Pulver ($\leq$ 0,5 mm) von Bi-(1,9)212 wurde durch Schmelzsynthese (20 min Aufschmelzen in Luft bei 1100°C, zerkleinern, und 12 h glühen bei 800°C) hergestellt. 20 g davon wurden in eine Ag-Kokille gefüllt und 20 min. bei 930°C unter $N_2$ erschmolzen. Nach einer Nachbehandlung von 20 h bei 800°C in $O_2$ und Abkühlung unter $N_2$ betrug die Stromdichte im Nullfeld $j_c$ = 50 A/cm$^2$.

## Vergleichsbeispiel 2

Es wurden die gleichen Prozesschritte durchgeführt wie beim Ausführungsbeispiel 3, jedoch diente als Ausgangssubstanz wiederum das kommerziell erhältliche Bi-2212-Pulver der Hoechst AG. Die Stromdichte im Nullfeld betrug hier $j_c$ = 20 A/cm$^2$.

## Ausführungsbeispiel 4

Entsprechend dem Verfahren in Ausführungsbeispiel 1 wurden Pulver von Bi-A212 mit A = 1,4, 1,7, 1,8 und 1,9 hergestellt und zu Tabletten verpresst. Ausschmelzen und Nachbehandlung waren identisch mit dem Verfahren gemäss Ausführungsbeispiel 1, mit der Ausnahme, dass die Nachbehandlung bei 800°C nur 4 h dauerte. Die Ergebnisse für $j_c$ im Nullfeld waren wie folgt:

| Zusammensetzung: | (1,4)212 | (1,7)212 | (1,8)212 | (1,9)212 |
|---|---|---|---|---|
| $j_c(B=0)$ [A/cm$^2$]: | 100 | 400 | 890 | 1380 |

Ausführungsbeispiel 5

Das Vorgehen war hier wie im Ausführungsbeispiel 4, jedoch war A = 1,85, 1,9 und 1,95. Die Zeit der Nachbehandlung bei 800°C betrug in diesem Fall 18 h. Die Ergebnisse für $j_c$ im Nullfeld waren wie folgt:

| Zusammensetzung: | (1,85)212 | (1,9)212 | (1,95)212 |
|---|---|---|---|
| $j_c(B=0)$ [A/cm$^2$]: | 1900 | 2040 | 2120 |

Wie aus diesen Ergebnissen (insbesondere auch der Figur) ersichtlich ist, können mit der Zusammensetzung nach der Erfindung und mit dem erfindungsgemässen Herstellungsverfahren Bi-Zweischicht-Supraleiter erzeugt werden, die sich durch ein deutlich verbessertes $j_c$ auch in höheren Magnetfeldern auszeichnen.

**Patentansprüche**

1. Verfahren zur Herstellung eines Hochtemperatur-Supraleiters vom Bi-Sr-Ca-Cu-O-Typ
   a) bei dem Oxide von Bi, Sr, Ca, und Cu und/oder Verbindungen dieser Elemente, welche sich bei erhöhten Temperaturen, insbesondere oberhalb 800 °C, zu Oxiden zersetzen, vermischt werden,
   b) bei dem die so entstandene Mischung aufgeschmolzen,
   c) danach die entstandene Schmelze zum Erstarren gebracht und
   d) der so entstandene Gußkörper in einer oxidierenden Atmosphäre nachbehandelt wird,
   dadurch gekennzeichnet,
   e) daß die Oxide und/oder Verbindungen von Bi, Sr, Ca und Cu in einem Verhältnis von Bi:Sr:Ca:Cu von (2 - x):2:1:2 mit $0,05 \leq x < 0,6$ oder
   f) in einem Verhältnis von Bi:Sr:Ca:Cu von 2:2:(1 + y):(2 + z) vermischt werden, mit $0 < y \leq 0,5$ und $0 < z \leq 0,5$ und
   g) daß die erstarrte Schmelze bei Temperaturen zwischen 400 °C und 880 °C in der oxidierenden Atmosphäre nachbehandelt wird.

2. Verfahren nach Anspruch 1, dadurch gekennzeichnet,
   a) daß die Mischung vor dem Schmelzen zunächst durch Glühen in Luft
   b) bei einer Temperatur unterhalb der Schmelztemperatur $T_m$ der Pulvermischung in eine Bi-Zweischichtverbindung umgewandelt wird.

3. Verfahren nach Anspruch 2, dadurch gekennzeichnet, daß die Glühtemperatur in Luft bei 850 °C liegt.

4. Verfahren nach einem der vorhergehenden Ansprüche, dadurch gekennzeichnet, daß die aufzuschmelzende Pulvermischung bei einer Temperatur von mindestens 20 K oberhalb deren Schmelztemperatur $T_m$ aufgeschmolzen wird.

5. Verfahren nach einem der vorhergehenden Ansprüche, dadurch gekennzeichnet,
   a) daß die erstarrte Schmelze nach der Nachbehandlung in der oxidierenden Atmosphäre unter Sauerstoffausschluß abgekühlt wird,
   b) insbesondere, daß die erstarrte Schmelze in $N_2$-Atmosphäre abgekühlt wird.

**Claims**

1. Process for the production of a high-temperature superconductor of the Bi-Sr-Ca-Cu-O type
   a) in which oxides of Bi, Sr, Ca and Cu and/or compounds of these elements, which decompose at elevated temperatures, in particular above 800°C, to form oxides, are mixed,
   b) in which the mixture produced in this way is fused,
   c) the melt produced is then caused to solidify
   d) the casting produced in this way is post-treated in an oxidizing atmosphere,
   characterized
   e) in that the oxides and/or compounds of Bi, Sr, Ca and Cu are mixed in a Bi:Sr:Ca:Cu ratio of (2 - x):2:1:2, where $0.05 \leq x < 0.6$ or
   f) in a Bi:Sr:Ca:Cu ratio of 2:2:(1 + y):(2 + z), where $0 < y \leq 0.5$ and $0 < z \leq 0.5$, and
   g) in that the solidified melt is aftertreated at temperatures between 400°C and 880°C in the oxidizing atmosphere.

2. Process according to Claim 1, characterized in that
   a) the mixture is first converted into a Bi two-layer compound before melting by annealing in air
   b) at a temperature below the melting point $T_m$ of the powder mixture.

3. Process according to Claim 2, characterized in that the annealing temperature in air is 850°C.

4. Process according to one of the preceding claims, characterized in that the powder to be fused is fused at a temperature of at least 20 K above its melting point $T_m$.

5. Process according to one of the preceding claims, characterized in that
   a) after the aftertreatment, the solidified melt is cooled in the oxidizing atmosphere with the exclusion of oxygen,
   b) in particular, in that the solidified melt is cooled in an $N_2$ atmosphere.

**Revendications**

1. Procédé de fabrication d'un supraconducteur haute température du type Bi-Sr-Ca-Cu-O
   a) lors duquel on mélange les oxydes de Bi, de Sr, de Ca et de Cu et/ou des composés de ces éléments, qui se décomposent en oxydes à températures élevées, en particulier au-dessus de 800°C,
   b) lors duquel on fait fondre le mélange ainsi obtenu,
   c) lors duquel on solidifie ensuite la masse fondue ainsi obtenue, et
   d) lors duquel on soumet la pièce moulée ainsi obtenue à un traitement ultérieur dans une atmosphère oxydante,
   caractérisé en ce que
   e) les oxydes et/ou les composés de Bi, de Sr, de Ca et de Cu sont mélangés dans un rapport de Bi:Sr:Ca:Cu de (2 - x):2:1:2 avec $0.05 \leq x < 0.6$ ou
   f) dans un rapport de Bi:Sr:Ca:Cu de 2:2:(1 + y):(2 + z), avec $0 < y \leq 0.5$ et $0 < z \leq 0.5$ et
   g) en ce que la masse fondue est soumise à un traitement ultérieur dans une atmosphère oxydante à des températures comprises entre 400°C et 880°C.

2. Procédé selon la revendication 1, caractérisé en ce que
   a) le mélange est converti avant la fusion tout d'abord par un recuit à l'air,
   b) à une température en-dessous de la température de fusion $T_m$ du mélange de poudres, en un composé Bi à deux couches.

3. Procédé selon la revendication 2, caractérisé en ce que la température de recuit à l'air se situe à 850°C.

4. Procédé selon l'une quelconque des revendications précédentes, caractérisé en ce que le mélange de poudres, destiné à être fondu, est soumis à fusion à une température d'au moins 20 K au-dessus de sa température de fusion $T_m$.

5. Procédé selon l'une quelconque des revendications précédentes, caractérisé en ce que

EP 0 482 221 B1

a) la masse fondue solidifiée est refroidie après le traitement ultérieur dans une atmosphère oxydante sous exclusion d'oxygène,
b) en particulier, en ce que la masse fondue solidifiée est refroidie dans une atmosphère de $N_2$.

Magnetic Field / Oe